(19) Europäisches Patentamt
European Patent Office
Office européen des brevets

(11) **EP 2 486 164 B1**

(12) **EUROPÄISCHE PATENTSCHRIFT**

(45) Veröffentlichungstag und Bekanntmachung des Hinweises auf die Patenterteilung:
**06.12.2017 Patentblatt 2017/49**

(21) Anmeldenummer: **10774113.4**

(22) Anmeldetag: **02.09.2010**

(51) Int Cl.:
*C23C 16/30* (2006.01)    *C23C 16/40* (2006.01)
*C23C 16/36* (2006.01)    *C23C 30/00* (2006.01)
*B23B 27/14* (2006.01)

(86) Internationale Anmeldenummer:
**PCT/AT2010/000317**

(87) Internationale Veröffentlichungsnummer:
**WO 2011/041804 (14.04.2011 Gazette 2011/15)**

(54) **SCHNEIDWERKZEUG ZUR BEARBEITUNG METALLISCHER WERKSTOFFE**

CUTTING TOOL FOR MACHINING OF METALLIC MATERIALS

OUTIL DE COUPE POUR L'USINAGE DES MATÉRIAUX MÉTALLIQUES

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **05.10.2009 AT 61409 U**

(43) Veröffentlichungstag der Anmeldung:
**15.08.2012 Patentblatt 2012/33**

(73) Patentinhaber: **Ceratizit Austria Gesellschaft M.b.H.**
**6600 Reutte (AT)**

(72) Erfinder:
• **KATHREIN, Martin**
 **A-6600 Reutte (AT)**
• **BÜRGIN, Werner**
 **CH-4450 Sissach (CH)**
• **CZETTL, Christoph**
 **A-8761 Pöls (AT)**
• **LECHLEITNER, Peter**
 **A-6644 Elmen (AT)**
• **THURNER, Josef**
 **A-6611 Heiterwang (AT)**

(56) Entgegenhaltungen:
EP-A1- 1 473 101    EP-A1- 2 208 561

EP-A2- 0 685 572

• LARSSON A ET AL: "Microstructure and properties of Ti(C,N) coatings produced by moderate temperature chemical vapour deposition", THIN SOLID FILMS, Bd. 402, Nr. 1-2, 1. Januar 2002 (2002-01-01), Seiten 203-210, XP004329954, ELSEVIER-SEQUOIA S.A. LAUSANNE [CH] ISSN: 0040-6090, DOI: 10.1016/S0040-6090(01)01712-6
• HALVARSSON M ET AL: "X-ray powder diffraction data for [kappa]-Al2O3", POWDER DIFFRACTION, Bd. 14, Nr. 1, März 1999 (1999-03), Seiten 61-63, XP009143215, AIP FOR JCPDS - INT. CENTRE FOR DIFFRACTION DATA [US] ISSN: 0885-7156
• BARBATTI C ET AL: "Influence of micro-blasting on the microstructure and residual stresses of CVD [kappa]-Al2O3 coatings", SURFACE & COATINGS TECHNOLOGY, Bd. 203, Nr. 24, 17. Juni 2009 (2009-06-17), Seiten 3708-3717, XP026284336, ELSEVIER SCIENCE S.A. [CH] ISSN: 0257-8972, DOI: 10.1016/j.surfcoat.2009.06.021
• POCHET L F ET AL: "CVD coatings: from cutting tools to aerospace applications and its future potential", SURFACE AND COATINGS TECHNOLOGY, Bd. 94-95, Nr. 1-3, Oktober 1997 (1997-10) , Seiten 70-75, XP002616832, ELSEVIER [CH] ISSN: 0257-8972, DOI: 10.1016/S0257-8972(97)00478-7

**Beschreibung**

Die vorliegende Erfindung betrifft ein Schneidwerkzeug zur Bearbeitung metallischer Werkstoffe. Insbesondere betrifft die Erfindung ein derartiges Schneidwerkzeug mit einem Hartmetallkörper und einer in zumindest einem Oberflächenbereich auf den Hartmetallkörper aufgebrachten mehrlagigen Beschichtung.

Derartige Schneidwerkzeuge kommen insbesondere als Wendeschneidplatten zum Drehen und für drehähnliche Schneidvorgänge an Eisen-Basiswerkstoffen, wie z.B. Stählen, Gusswerkstoffen und nichtrostenden Stählen, zum Einsatz. Die Schneidwerkzeuge werden dabei insbesondere für feine, mittlere und grobe Bearbeitungsoperationen eingesetzt. Feine, mittlere und grobe Bearbeitung wird dabei durch Unterteilung in Bereiche von geringen Spanquerschnitten (bei hohen Schnittgeschwindigkeiten) bis zu großen Spanquerschnitten (bei geringeren Schnittgeschwindigkeiten) unterschieden.

Es ist bekannt, zur Erhöhung der Lebensdauer auf verschleißbeanspruchten Schneidwerkzeugen aus verschleißbeständigem Hartmetall mittels thermisch aktivierter chemischer Schichtabscheidung aus der Dampf- bzw. Gasphase (Chemical Vapour Deposition, CVD) hoch verschleißfeste Hartstoffschichten aufzubringen. Die Hartstoffschichten werden dabei oftmals als Mehrlagenschichten mit unterschiedlichen chemischen Zusammensetzungen aufgebracht. Als derartige Mehrlagenschichten können Schichten von $TiC_xN_yO_zB_v$ und $Al_2O_3$ zum Einsatz kommen, wobei gilt x + y + z + v = 1. Die einzelnen Parameter x, y, z und v können dabei verschiedene Werte annehmen, insbesondere können ein oder mehrere der Parameter in den einzelnen Schichten teilweise den Wert 0 haben. Mit derartigen Mehrlagenschichten können Oberflächen mit Härtewerten (ermittelt nach EN ISO 14577-1) im Bereich von 15 bis 40 GPa erzielt werden. Da die mittels CVD-Verfahren erzeugten Oberflächen meist eine (poly-) kristalline Struktur aufweisen, wird in vielen Fällen eine Glättung der (äußersten) Oberfläche vorgenommen, z.B. durch Druckstrahlglättung mit trockenem oder nassem Strahl mit meist keramischen Abrasivkörpern.

Es ist bekannt, als äußere Schicht von Schneidwerkzeugen $Al_2O_3$ zu verwenden. Teilweise wird auf dieser äußeren Schicht noch eine dünne Schicht aus TiN, $TiC_xN_y$ (mit x + y = 1) oder eine Kombination solcher Schichten abgeschieden. $Al_2O_3$ kann in einer Vielzahl verschiedener Phasen kristallisieren, wobei in Bezug auf die Abscheidung dünner $Al_2O_3$-Schichten mittels CVD-Verfahren für Schneidwerkzeug-Hartstoffschichten zwei dieser Phasen hauptsächlich eine Rolle spielen: $\alpha$-$Al_2O_3$ und $\kappa$-$Al_2O_3$. $\alpha$-$Al_2O_3$ ist eine thermodynamisch stabile hexagonale Phase und $\kappa$-$Al_2O_3$ ist eine thermodynamisch metastabile Phase. Es können Schichten aus (im Wesentlichen) reinem $\alpha$-$Al_2O_3$ oder Schichten aus (im Wesentlichen) reinem $\kappa$-$Al_2O_3$ abgeschieden werden. Es können aber auch Schichten ausgebildet werden, die eine Mischung aus $\alpha$-$Al_2O_3$ und $\kappa$-$Al_2O_3$ aufweisen, wobei unterschiedliche Mischungsverhältnisse erzielt werden können. Durch eine geeignete Wahl der unmittelbar unter der $Al_2O_3$-Schicht abgeschiedenen Schichten (insbesondere deren genaue chemische Zusammensetzung, Morphologie und deren Textur) sowie durch eine geeignete Auswahl der Beschichtungsparameter bei dem CVD-Verfahren zur Ausbildung der $Al_2O_3$-Schicht kann in modernen CVD-Anlagen zuverlässig und zielgerichtet eine Abscheidung von entweder $\alpha$-$Al_2O_3$ oder $\kappa$-$Al_2O_3$ erfolgen.

Die Herstellung der beschriebenen Mehrlagenschichten im CVD-Verfahren erfolgt üblicherweise mit einer thermischen Aktivierung bei Temperaturen oberhalb von 500 °C. Die Schichtbildung erfolgt somit bei hohen Temperaturen und es erfolgt anschließend in der Regel eine Abkühlung auf Raumtemperatur. Bei der Bearbeitung metallischer Werkstoffe unter Einsatz der Schneidwerkzeuge erhöhen sich die Temperaturen in den Mehrlagenschichten teilweise wieder auf hohe Temperaturen. Aufgrund der Herstellung der Schichten bei hohen Temperaturen und der unterschiedlichen thermischen Ausdehnungskoeffizienten der einzelnen Schichten bilden sich in den verschiedenen Schichten bei dem Abkühlen auf Raumtemperatur Zug- bzw. Druckspannungen aus. Diese unterschiedlichen Spannungen in den Schichten können dazu führen, dass in den äußeren Schichten des Schneidwerkzeugs bei dem Abkühlen auf Raumtemperatur oder bei der Werkstoffbearbeitung Rissbildung auftritt. Diese Rissbildung und zwischen den Schichten verbleibende Spannungsgradienten stehen in unmittelbarem Zusammenhang mit der erreichbaren Schneidwerkzeug-Lebensdauer, da ausgehend von den gebildeten Rissen und/oder bedingt durch hohe verbleibende Spannungsgradienten Abplatzungen von Bereichen ein oder mehrerer Schichten begünstigt auftreten können. Besonders kritische Stellen, an denen eine Ablösung von Teilen einer oder mehrerer Schichten auftreten kann, bilden insbesondere die Schnittstellen zwischen einer Schicht und einer unmittelbar daran anschließenden nächsten Schicht.

Bei den oberhalb beschriebenen Mehrlagenschichten existiert eine Vielzahl von Kombinationsmöglichkeiten in Bezug auf Schichtabfolge, Auswahl der chemischen Zusammensetzung der einzelnen Schichten, Schichtdicken und Texturierung der einzelnen Schichten. Für die Herstellung eines Schneidwerkzeugs, das besonders gute Eigenschaften, insbesondere eine hohe Lebensdauer, aufweisen soll, kommt es ganz besonders auf die genaue Abfolge der einzelnen Schichten, deren Textur und die in den einzelnen Schichten verbleibenden Zug- bzw. Druckspannungen an. Es hat sich gezeigt, dass insbesondere eine Veränderung der Textur in einer Schicht der Mehrlagenschichten eine erhebliche Auswirkung auf die erzielte Güte des Schneidwerkzeugs haben kann. Das Zusammenspiel der genauen Schichtabfolge mit einer Glättung der (äußersten) Oberfläche durch z.B. ein Druckstrahlverfahren kann einen wesentlichen Einfluss auf die Eigenschaften des gebildeten Schneidwerkzeugs haben. In diesem Zusammenhang wurde insbesondere festgestellt, dass die Anwendung eines Druckstrahlverfahrens in Abhängigkeit von der Schichtabfolge in der Mehrlagenschicht und in Abhängigkeit von der äußersten zu glättenden Schicht entscheidende Auswirkungen auf die erzielte Qualität des Schneidwerkzeugs hat.

Üblicherweise wird im Hinblick auf dessen thermische Stabilität die Verwendung von $\alpha$-Al$_2$O$_3$ für Hartstoffschichten zur Werkzeugbeschichtung als vorteilhaft gegenüber einer Verwendung von $\kappa$-Al$_2$O$_3$ angesehen.

EP 1 696 051 A1 beschreibt eine Hartstoffbeschichtung für Schneidwerkzeugeinsätze mit einer polykristallinen Schicht aus 100% $\alpha$-Al$_2$O$_3$, die auf einer TiC$_x$N$_y$-Schicht ausgebildet ist. Die vorgegebene Schichtfolge und insbesondere die Verwendung der 100% $\alpha$-Al$_2$O$_3$-Schicht sollen sich positiv auf die Spannungsverhältnisse in der Werkzeugbeschichtung auswirken.

EP 1 473 101 A offenbart mehrfachbeschichtete Schneidwerkzeuge, die eine innere Schicht enthaltend TiN und/oder TiCN und/oder TiCNO, eine Zwischenschicht aus TiBN oder TiBNO, sowie eine Außenschicht aus $\alpha$-Al$_2$O$_3$ aufweisen. Die Schichten werden durch CVD abgeschieden.

EP 2 208 561 A offenbart mehrfachbeschichtete Schneidwerkzeuge, die unter anderem eine innere Schicht aus TiN, eine Zwischenschicht aus TiCN, eine weitere Schicht aus TiCNO, sowie eine Außenschicht aus $\kappa$-Al2O3 aufweisen. Die TiCN-Schicht wird durch MT-CVD abgeschieden. Es ist Aufgabe der vorliegenden Erfindung, ein Schneidwerkzeug zur Bearbeitung metallischer Werkstoffe mit einem Hartmetallkörper und einer in zumindest einem Oberflächenbereich auf den Hartmetallkörper aufgebrachten mehrlagigen Beschichtung bereitzustellen, das verbesserte Eigenschaften und verbesserte Haltbarkeit bei verschiedenen Schnittbedingungen erzielt.

Die Aufgabe wird durch ein Schneidwerkzeug nach Anspruch 1 gelöst. Vorteilhafte Weiterbildungen sind in den abhängigen Ansprüchen angegeben. Ein erfindungsgemäßes Schneidwerkzeug zur Bearbeitung metallischer Werkstoffe weist einen Hartmetallkörper und eine in zumindest einem Oberflächenbereich auf den Hartmetallkörper aufgebrachte mehrlagige Beschichtung auf. Die mehrlagige Beschichtung weist in einer Richtung von dem Hartmetallkörper zu der Oberfläche des Schneidwerkzeugs in der folgenden Reihenfolge auf: (i.) zumindest eine Schicht TiC$_{x1}$N$_{y1}$ (mit x1 + y1 = 1, x1 $\geq$ 0, y1 > 0); (ii.) zumindest eine Schicht TiC$_{x2}$N$_{y2}$O$_{z2}$ (mit x2 + y2 + z2 = 1, 0,01 $\leq$ z2 $\leq$ 0,02 und 0,5 $\leq$ x2 $\leq$ 0,85); (iii.) zumindest eine Schicht TiN oder TiC$_{x31}$N$_{y31}$ (mit 0,2 $\leq$ x31 $\leq$ 0,8 und x31 + y31 = 1) oder TiN$_{y32}$B$_{y32}$ (mit 0,0001 $\leq$ v32 $\leq$ 0,05 und y32 + v32 = 1); (iv.) zumindest eine Schicht TiN$_{y41}$B$_{v41}$O$_{z41}$ (mit y41 + v41 + z41 = 1 und 0,0001 $\leq$ v41 $\leq$ 0,05 und 0,01 $\leq$ z41 $\leq$ 0,6) oder TiC$_{x42}$N$_{y42}$O$_{z42}$ (mit x42 + y42 + z42 = 1 und 0 $\leq$ y42 $\leq$ 0,5 und 0,01 $\leq$ z42 $\leq$ 0,6); und (v.) zumindest eine Außenschicht $\kappa$-Al$_2$O$_3$. Die zumindest eine Schicht TiC$_{x2}$N$_{y2}$O$_{z2}$ weist eine Texturierung in der (311)-Richtung mit einem Texturkoeffizienten TC$_{(311)}$ $\geq$ 1,3 auf. Die unter (iii.) aufgeführte Schicht weist somit TiN oder TiC$_{x31}$N$_{y31}$ oder TiN$_{y32}$B$_{y32}$ auf. Die unter (iv.) aufgeführte Schicht weist TiN$_{y41}$B$_{v41}$O$_{z41}$ oder TiC$_{x42}$N$_{y42}$O$_{z42}$ auf.

Bei den gewählten Bezeichnungen ist das Folgende zu beachten: bzgl. der Schicht (i.) TiC$_{x1}$N$_{y1}$ ist auch xl = 0 möglich; bei der Schicht (zweite Alternative zu iv.) TiC$_{x42}$N$_{y42}$O$_{z42}$ ist auch y42 = 0 möglich. Die zumindest eine Schicht TiC$_{x1}$N$_{y1}$ weist bevorzugt eine Schichtdicke zwischen 0,1 $\mu$m und 1 $\mu$m, insbesondere zwischen 0,1 $\mu$m und 0,8 $\mu$m, auf. Die zumindest eine Schicht TiC$_{x2}$N$_{y2}$O$_{z2}$ weist bevorzugt eine Schichtdicke zwischen 5 $\mu$m und 15 $\mu$m, insbesondere zwischen 8 $\mu$m und 14 $\mu$m, auf. Die zumindest eine Schicht, die aus TiN oder TiC$_{x31}$N$_{y31}$ oder TiN$_{y32}$B$_{v32}$ bestehen kann, weist bevorzugt eine Schichtdicke zwischen 0,1 $\mu$m und 3 $\mu$m auf. Die zumindest eine Schicht, die aus TiN$_{y41}$B$_{y41}$O$_{z41}$ oder TiC$_{x42}$N$_{y42}$O$_{z42}$ bestehen kann, weist bevorzugt eine Schichtdicke zwischen 0,01 $\mu$m und 0,5 $\mu$m auf. Die zumindest eine Außenschicht $\kappa$-Al$_2$O$_3$ weist bevorzugt eine Schichtdicke zwischen 2 $\mu$m und 10 $\mu$m, insbesondere zwischen 3,5 $\mu$m und 6,5 $\mu$m auf.

Es wurde gefunden, dass sich mit der angegebenen Schichtabfolge und insbesondere der Kombination der Außenschicht $\kappa$-Al$_2$O$_3$ mit der bevorzugten Texturierung in der (311)-Richtung der TiC$_{x2}$N$_{y2}$O$_{z2}$-Schicht und den zwischen diesen angeordneten Zwischenschichten die Spannungsverhältnisse in der gesamten mehrlagigen Beschichtung besonders gut einstellen lassen. Insbesondere können nach der Schichtabscheidung mit einem mechanischen Glättungsverfahren, insbesondere durch Druckstrahlglättung, bevorzugte Spannungsverhältnisse eingestellt werden. Die angegebene Schichtabfolge der mehrlagigen Beschichtung stellt dabei unter anderem einen besonders guten und stabilen Übergang zwischen den einzelnen Schichten von dem Hartmetallkörper bis zu der Außenschicht sicher und die gewünschten Spannungsverhältnisse in den einzelnen Schichten lassen sich zuverlässig einstellen. Mit den angegebenen Merkmalen kann erreicht werden, dass sich in einem äußersten Randbereich der $\kappa$-Al$_2$O$_3$-Schicht eine Druckspannung einstellen lässt, die eine stabile Oberfläche bei der Benutzung des Schneidwerkzeugs bewirkt, und in Richtung der weiter innen liegenden Schichten ein Übergang zu einer Zugspannung erfolgt. Eine Zugspannung bezeichnet dabei eine entlang der Schichtebene wirkende Spannung, die in Richtung einer Verkleinerung der Schichtfläche wirkt. Eine Druckspannung bezeichnet eine entlang der Schichtebene wirkende Spannung, die in Richtung einer Vergrößerung der Schichtfläche wirkt. Es hat sich insbesondere herausgestellt, dass sich in einer Richtung von der Oberfläche zu dem Hartmetallkörper ein besonders vorteilhafter Spannungsgradient ausbilden lässt. Aufgrund dieser Merkmale werden verbesserte Eigenschaften und verbesserte Haltbarkeit bei verschiedenen Schnittbedingungen erzielt. Durch die Ausbildung der Außenschicht als $\kappa$-Al$_2$O$_3$-Schicht lassen sich die Eigenschaften des Schneidwerkzeugs positiv beeinflussen, da $\kappa$-Al$_2$O$_3$ im Vergleich zu $\alpha$-Al$_2$O$_3$ bei einem mechanischen Glättungsverfahren ein höheres Maß an plastischer Verformung ermöglicht und sich Druckspannungen an der Oberfläche besser einstellen lassen. Auf der Oberfläche der zumindest einen Außenschicht $\kappa$-Al$_2$O$_3$ können noch eine oder mehrere weitere Schichten ausgebildet sein. Bei der Verwendung des Schneidwerkzeugs und einer damit verbundenen Erhitzung an der Oberfläche bewirken die hohe Zähigkeit der $\kappa$-Al$_2$O$_3$-Schicht und der geringere Härteverlust bei hohen Temperaturen im Vergleich zu $\alpha$-Al$_2$O$_3$ verbesserte Eigenschaften und verbesserte Haltbarkeit. Aufgrund der verglichen mit $\alpha$-Al$_2$O$_3$ geringeren Wärmeleitfähigkeit wird Wärme nur in geringerem Maß zu den weiter innen liegenden Schichten übertragen und dadurch eine unerwünscht starke Erhitzung des Schneidwerkzeugs vermieden. Die beschriebenen Schichten weisen jeweils eine polykristalline Struktur auf. Die mehrlagige Beschichtung ist insbesondere mittels thermisch aktivierter chemischer Gasphasenabscheidung (CVD, chemical vapour deposition) gebildet. Die mehrlagige Beschichtung kann zumindest in einem Oberflächenbereich des Schneidwerkzeugs aufgebracht sein, der bei einem Einsatz des Schneidwerkzeugs mit einem zu bearbeitenden Werkstoff in Eingriff gelangt. Bevorzugt kann das Schneidwerkzeug durch eine Wendeschneidplatte gebildet sein. Es kann bevorzugt für die Bearbeitung von Eisen-Basiswerkstoffen bestimmt sein. Gemäß einer Weiterbildung grenzen die beschriebenen Schichten (ohne weitere dazwischen ausgebildete Schichten) direkt aneinander an. Die einzelnen angegebenen Schichten können auch selbst mehrlagig ausgebildet sein und in den einzelnen Lagen z.B. auch unterschiedliche stöchiometrische Verhältnisse aufweisen. Die Angabe bezüglich der Texturierung im Rahmen dieser Beschreibung bezieht sich immer auf die Millerschen Indizes in der hkl-Notation. Dabei erfolgt für die jeweiligen Schichten eine Zuordnung der hkl-Werte entsprechend der Notation der JCPDS-Datenbank (bzw. JCPDF-Datenbank). Die Berechnung des Texturkoeffizienten TC erfolgt dabei nach der Formel:

$$TC_{(hkl)} = \frac{I_{(hkl)} / I_{0,(hkl)}}{1/n \sum\limits_{n} I_{(hkl)} / I_{0,(hkl)}}$$

wobei $I_{(hkl)}$, die Intensität bezeichnet, die bezüglich dem jeweiligen (hkl)-Wert gemessen wurde (aus zumindest einem entsprechenden Peak), $I_{0,(hkl)}$ die entsprechende normierte Intensität gemäß der JCPDS- (bzw. JCPDF-) Datenbank bezeichnet und n als Index über alle bezüglich der jeweiligen Zusammensetzung erwarteten Intensitäten zu (hkl)-Werten verläuft.

Gemäß einer Ausgestaltung weist die zumindest eine Außenschicht $\kappa$-Al$_2$O$_3$ eine mittlere Spannung zwischen -100 MPa (Druckspannung) und 700 MPa (Zugspannung) auf. In diesem Zusammenhang bezeichnet "mittlere Spannung" einen Wert, der in einer Richtung senkrecht zu der Schichtebene über die gesamte Schichtdicke gemittelt wird. Dabei ist zu beachten, dass entlang dieser Richtung insbesondere ein Teil der Schicht eine Zugspannung und ein anderer Teil der Schicht eine Druckspannung aufweisen kann. Die Spannung lässt sich dabei insbesondere über XRD-Messungen (X-Ray Diffraction; Röntgentbeugung) und die bekannte $\sin^2\psi$-Methode bestimmen (beschrieben z.B. unter: I.C. Noyan, J.B. Cohen, Residual Stress Measurement by Diffraction and Interpretation, Springer-Verlag, New York, 1987 (pp 117-130)). Auch andere im Folgenden beschriebene Spannungen in Schichten können über diese Methode bestimmt werden. Es wurde gefunden, das eine mittlere Spannung in dem angegebenen Bereich zu einer besonders guten Haltbarkeit des Schneidwerkzeugs führt. Die Höhe der Spannung lässt sich z.B. durch ein Druckstrahlglättungsverfahren einstellen, wobei als verschiedene Parameter in dem Druckstrahlglättungsverfahren die Materialzusammensetzung des in dem Druckstrahl verwendeten Materials (z.B. keramische Abrasivkörper), die Größenverteilung des Materials, der Strahldruck sowie zu einem geringeren Maß die Behandlungsdauer und der Winkel, unter dem der Strahl auf die Oberfläche gerichtet wird, variiert werden können.

Gemäß einer Ausgestaltung weist ein äußerster Bereich der zumindest einen Außenschicht $\kappa$-Al$_2$O$_3$ eine mittlere Druckspannung auf. Dies lässt sich mit der zuvor beschriebenen Behandlung erzielen. Es ist zu beachten, dass diese Druckspannung auch in Kombination mit einer mittleren Zugspannung über die gesamte Außenschicht $\kappa$-Al$_2$O$_3$ realisiert werden kann, indem in der Außenschicht $\kappa$-Al$_2$O$_3$ über die Schichtdicke ein entsprechender Druckgradient eingestellt wird. Da die Außenschicht aus $\kappa$-Al$_2$O$_3$ gebildet ist, lässt sich ein solcher Druckgradient zuverlässig einstellen. Gemäß einer bevorzugten Ausgestaltung weist die zumindest eine Schicht TiC$_{x1}$N$_{y1}$ eine Schichtdicke zwischen 0,1 $\mu$m und 1 $\mu$m auf, weist die zumindest eine Schicht TiC$_{x2}$N$_{y2}$O$_{z2}$ eine Schichtdicke zwischen 5 $\mu$m und 15 $\mu$m auf, weist die zumindest eine Schicht, die aus TiN oder TiC$_{x31}$N$_{y31}$ oder TiN$_{y32}$B$_{v32}$ gebildet ist, eine Schichtdicke zwischen 0,1 $\mu$m und 3 $\mu$m auf, weist die zumindest eine Schicht, die aus TiN$_{y41}$B$_{v41}$O$_{z41}$ oder TiC$_{x42}$N$_{y42}$O$_{z42}$ gebildet ist, eine Schichtdicke zwischen 0,01 $\mu$m und 0,5 $\mu$m auf, und weist die zumindest eine Außenschicht $\kappa$-Al$_2$O$_3$ eine Schichtdicke zwischen 2 $\mu$m und 10 $\mu$m auf. Es wurde gefunden, dass bei der Ausbildung der mehrlagigen Beschichtung mit diesen Dicken der einzelnen Schichten die gewünschten Eigenschaften besonders gut erreicht werden können. Gemäß einer Ausgestaltung weist die zumindest eine Außenschicht $\kappa$-Al$_2$O$_3$ in einer Ebene parallel zu der Schichtoberfläche eine Korngröße kleiner als 3 $\mu$m auf. Diese Korngröße kann bei $\kappa$-Al$_2$O$_3$ über die Parameter des CVD-Verfahrens eingestellt werden. Es wurde gefunden, dass mit dieser Korngröße eine besonders haltbare Beschichtung mit einer glatten Oberfläche erreicht wird. Die zumindest eine Schicht TiC$_{x2}$N$_{y2}$O$_{z2}$ weist einen Anteil $0,01 \leq z2 \leq 0,02$ auf. Ein solcher endlicher Anteil an Sauerstoff in der Schicht lässt sich durch eine gezielte Dotierung mit Sauerstoff bei dem CVD-Verfahren über CO in dem Prozessgas erzielen. Der Wert von z2 lässt sich zum Beispiel über die Flussmenge an CO im Prozessgas einstellen. Insbesondere die graduelle Dotierung mit Sauerstoff in Verbindung mit der Vorzugs-texturierung der $TiC_{x2}N_{y2}O_{z2}$-Schicht und der Außenschicht aus $\kappa$-$Al_2O_3$ führt zu dem Effekt, dass sich die Spannungsverhältnisse in den Schichten zuverlässig einstellen lassen und eine gute Verbindung der einzelnen Schichten gewährleistet ist.

Bevorzugt ist der Hartmetallkörper aus WC mit 5,5-10 Gew.% Co und 5-9 Gew.% kubischen Karbiden zumindest eines Metalls der Gruppen IVb, Vb, VIb des Periodensystems gebildet. Das zumindest eine Metall der Gruppen IVb, Vb oder VIb des Periodensystems wird dabei bevorzugt durch Ti, Hf, Zr oder eine Kombination von diesen gebildet. Insbesondere auf einem derart gebildeten Hartmetallkörper führt die angegebene mehrlagige Beschichtung aufgrund der entsprechenden physikalischen und chemischen Eigenschaften zu einem besonders widerstandsfähigen und haltbaren Schneidwerkzeug. Bevorzugt weist der Hartmetallkörper dabei eine Randzone mit einer Dicke zwischen 5 $\mu$m und 30 $\mu$m, insbesondere zwischen

15 $\mu$m und 25 $\mu$m, auf, in der der Anteil an Co im Verhältnis zum Inneren des Hartmetallkörpers erhöht und der Anteil an kubischen Karbiden zumindest eines Metalls der Gruppen IVb, Vb, VIb des Periodensystems im Verhältnis zum Inneren des Hartmetallkörpers verringert ist.

Es hat sich gezeigt, dass insbesondere die Ausbildung der zumindest einen Außenschicht als eine einlagige Schicht $\kappa$-$Al_2O_3$ zu einem besonders guten Ergebnis führt. Unter "einlagig" wird dabei insbesondere verstanden, dass zumindest überwiegend eine einzelne Schicht von Kristalliten vorliegt und nicht überwiegend mehrere Kristallite in der Richtung senkrecht zur Schichtebene übereinander angeordnet sind. In einer solchen Außenschicht lassen sich die Druckverhältnisse besonders zuverlässig einstellen.

Wenn die mehrlagige Beschichtung angrenzend an den Hartmetallkörper zumindest eine Schicht TiN mit einer Schichtdicke bis zu 1 $\mu$m aufweist, wird eine besonders gute Anbindung der mehrlagigen Beschichtung an den Hartmetallkörper erreicht. Die zumindest eine Schicht $TiC_{x2}N_{y2}O_{z2}$ weist plattenartige, stängelige Kristalle auf. Ferner weist die zumindest eine Schicht, die durch TiN oder $TiC_{x31}N_{y31}$ oder $TiN_{y32}B_{v32}$ gebildet ist, bevorzugt feinkörnige bis lamellar verästelte Kristalle auf. Ebenso weist bevorzugt die zumindest eine Schicht, die durch $TiN_{y41}B_{v41}O_{z41}$ oder $TiC_{x42}N_{y42}O_{z42}$ gebildet ist, feinkörnige bis lamellar verästelte Kristalle auf. Über diese Strukturen wird ein guter Zusammenhalt der Schichten untereinander und die Ausbildung der Außenschicht $\kappa$-$Al_2O_3$ mit kleinen Korngrößen erreicht.

Gemäß einer Ausgestaltung ist die zumindest eine Außenschicht $\kappa$-$Al_2O_3$ mechanisch geglättet, insbesondere durch Druckstrahlglättung gestrahlt. Diese Art der Bearbeitung spiegelt sich unmittelbar in den erzeugten Eigenschaften des Schneidwerkzeugs wieder und ist an der verbleibenden Struktur der Außenschicht zu erkennen. Die mechanische Glättung führt einerseits zu einer glatten Außenfläche der Außenschicht und ermöglicht andererseits gleichzeitig, die gewünschten Spannungsverhältnisse in der Beschichtung zu generieren. Durch geeignete Anpassung der Parameter eines Druckstrahlglättungsverfahrens lassen sich beide Effekte in der gewünschten Weise erzielen. Als verschiedene Parameter des Druckstrahlglättungsverfahrens können u.a. die Materialzusammensetzung des in dem Druckstrahl verwendeten Materials (z.B. keramische Abrasivkörper), die Größenverteilung des Materials, der Strahldruck sowie zu einem geringeren Maß die Behandlungsdauer und der Winkel, unter dem der Strahl auf die Oberfläche gerichtet wird, variiert werden.

Gemäß einer bevorzugten Weiterbildung weist die zumindest eine Außenschicht $\kappa$-$Al_2O_3$ eine Vorzugs-Texturierung in der (110)-Richtung mit einem Texturkoeffizienten $TC_{(110)} \geq 1,3$ auf. Dabei weist die Außenschicht bevorzugt auch eine Vorzugs-Texturierung in der (004)-Richtung mit einem Texturkoeffizienten $TC_{(004)} \geq 1,3$ und eine Vorzugs-Texturierung in der (015)-Richtung mit einem Texturkoeffizienten $TC_{(015)} \geq 1,3$ auf. Bevorzugt gilt dabei $TC_{(110)} \geq TC_{(004)}$ und $TC_{(110)} > TC_{(015)}$. Es hat sich gezeigt, dass insbesondere bei einer solchen Texturierung der Außenschicht in Zusammenspiel mit den weiteren Schichten die Spannungsverhältnisse in der Beschichtung besonders gut eingestellt werden können und eine glatte Oberfläche erzielt wird. Erfindungsgemäß weist die Schicht $TiC_{x2}N_{y2}O_{z2}$ einen Sauerstoffgehalt z2 im Bereich zwischen 0,01 und 0,02 auf. Es wurde gefunden, dass insbesondere mit diesem Sauerstoffgehalt besonders bevorzugte Eigenschaften des Schneidwerkzeugs erreicht werden. Dabei spielen insbesondere drei Effekte eine entscheidende Rolle. Mit steigendem Wert für z2 tritt eine Strukturverfeinerung der $TiC_{x2}N_{y2}O_{z2}$-Schicht auf, sodass sich gemäß dem Hall-Petch-Effekt eine höhere Zähigkeit der Schicht ergibt. Ferner wird in dem Bereich $0,01 \leq z2 \leq 0,02$ ein Minimum der verbleibenden Zugspannung in der $TiC_{x2}N_{y2}O_{z2}$-Schicht nach deren Bildung erreicht. Zudem wird in diesem Bereich eine besonders hohe Eindringhärte dieser Schicht erreicht. Diese Effekte wirken sich insbesondere auf die Verschleißfestigkeit des Schneidwerkzeugs positiv aus.

Weitere Vorteile und Weiterbildungen der Erfindung ergeben sich aus der folgenden Beschreibung von Ausführungsbeispielen unter Bezugnahme auf die Figuren.

Fig. 1  zeigt ein rasterelektronenmikroskopisches Bild einer Bruchfläche einer mehrlagigen Beschichtung auf einem Hartmetallkörper gemäß einer Ausführungsform.

Fig. 2  zeigt ein lichtmikroskopisches Bild einer Schlifffläche der mehrlagigen Beschichtung auf dem Hartmetallkörper.

Fig. 3  zeigt ein rasterelektronenmikroskopisches Bild einer Oberfläche der $TiC_{x2}N_{y2}O_{z2}$-Schicht.

Fig.  4 zeigt eine (nicht maßstabsgerechte) schematische Darstellung der Schichtabfolge bei dem Schneidwerkzeug.

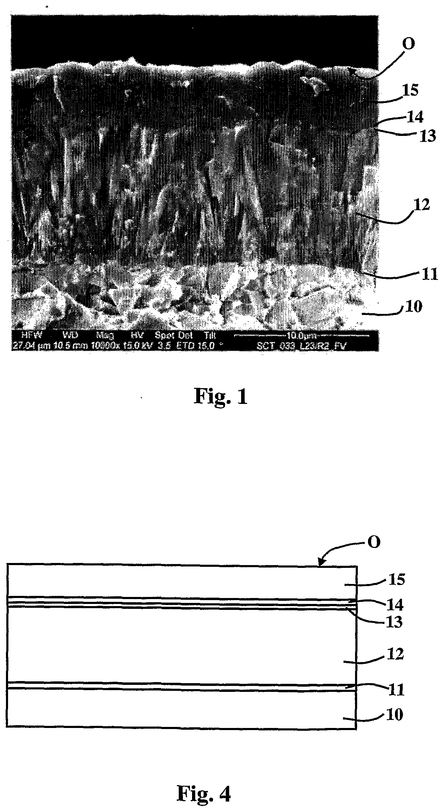

Eine Ausführungsform wird im Folgenden unter Bezug auf die Fig. 1 bis Fig. 4 beschrieben. Bei dem Schneidwerkzeug gemäß der im Folgenden beschriebenen Ausführungsform handelt es sich um eine Wendeschneidplatte zur spanenden Bearbeitung von metallischen Werkstoffen. Das Schneidwerkzeug ist bei der beispielhaften Ausführungsform eine Wendeschneidplatte zum Drehen und zur drehähnlichen Schneidbearbeitung von Eisen-Basiswerkstoffen, z.B. Stählen, Gusswerkstoffen und nichtrostenden Stählen. Das Schneidwerkzeug ist für feine, mittlere und grobe Bearbeitung ausgelegt. Bei dem beispielhaften Schneidwerkzeug handelt es sich insbesondere um einen Schneideinsatz zum Drehen für den ISO P, M, K 15-35 Bereich, insbesondere für den P15-P35 Bereich. Dieser Anwendungsbereich weist ein großes Beanspruchungsprofil auf und umfasst unterschiedlichste Anwendungen, wie z.B. Trocken- und Nasszerspanung mit kontinuierlichen (bzw. glatten) oder unterbrochenen Schnittoperationen auf unterschiedlichen eisenhaltigen Werkstoffklassen, wie z.B. legierten Stählen, nichtrostenden Stählen oder Gusswerkstoffen mit unterschiedlichsten Legierungskomponenten.

Das Schneidwerkzeug weist einen Hartmetallkörper -10- auf, der mit zumindest einem funktionalen Oberflächenbereich versehen ist, insbesondere einer Schneidkante und daran anschließenden spanleitenden Strukturen. Der Hartmetallkörper ist bei dem Ausführungsbeispiel aus WC mit 5,5-10 Gew.% Co und 5-9 Gew.% kubischen Karbiden zumindest eines Metalls der Gruppen IVb, Vb, VIb des Periodensystems gebildet. In dem im folgenden beschriebenen Beispiel weist der Hartmetallkörper insbesondere $7 \pm 1$ Gew.% Co und $8,1 \pm 0,5$ Gew.% Ta(Nb)C mit einer Korngröße zwischen 1 $\mu$m und 2 $\mu$m auf (Spezifikation H718). Bei dem Beispiel weist der Hartmetallkörper -10- eine Randzone (angrenzend an die im Folgenden beschriebene mehrlagige Beschichtung) mit einer Dicke zwischen 5 $\mu$m und 30 $\mu$m auf, in der der Anteil an Co im Verhältnis zum Inneren des Hartmetallkörpers erhöht (angereichert) und der Anteil an kubischen Karbiden zumindest eines Metalls der Gruppen IVb, Vb, VIb des Periodensystems im Verhältnis zum Inneren des Hartmetallkörpers verringert (abgereichert) ist.

Der Hartmetallkörper -10- ist in zumindest einem funktionalen Oberflächenbereich mit einer mehrlagigen Beschichtung versehen, die durch eine Mehrzahl von unterschiedlichen Schichten gebildet ist. Die unterschiedlichen Schichten sind alle nacheinander mittels CVD-Verfahren auf der Oberfläche des Hartmetallkörpers -10- abgeschieden. Zur Abscheidung der verschiedenen Schichten kommen die Precursoren $TiCl_4$, $CH_3CN$, $CH_4$, $H_2$, $N_2$, CO, $CO_2$, HCl, $H_2S$ und $AlCl_3$ zum Einsatz, wie im Folgenden noch eingehender beschrieben wird. $AlCl_3$ kann dabei insbesondere über metallisches Al und HCl erzeugt und bereitgestellt werden. Die Schichten sind in einem LPCVD-Verfahren (<u>l</u>ow <u>p</u>ressure <u>c</u>hemical <u>v</u>apour <u>d</u>eposition; chemische Gas- bzw. Dampfphasenabscheidung unter niedrigem Druck) in einer Beschichtungsanlage vom Typ SuCoTec SCT600-TH abgeschieden, die gemäß ihrer Betriebsanleitung betrieben wurde.

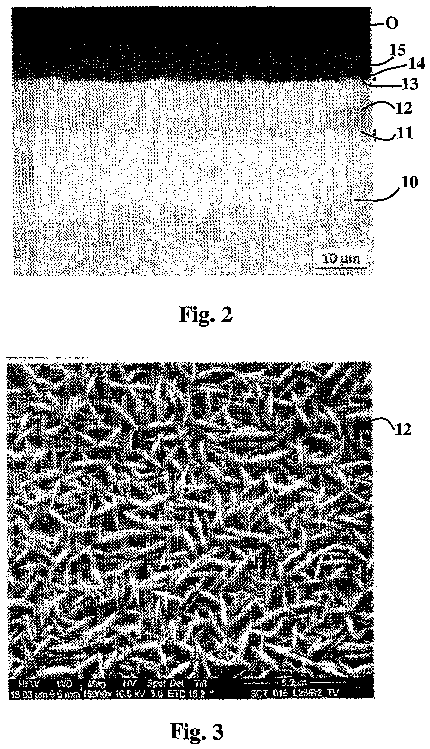

Unmittelbar auf der Oberfläche des Hartmetallkörpers -10- ist eine Schicht -11- $TiC_{x1}N_{y1}$ mit x1 + y1 = 1, x1 $\geq$ 0, y1 > 0 ausgebildet, die eine Dicke zwischen 0,1 $\mu$m und 1 $\mu$m aufweist. Bei dem in den Fig. 1 und 2 dargestellten Beispiel ist die Schicht -11- durch eine ca. 0,5 $\mu$m bis 1 $\mu$m dicke Schicht TiN (d.h. x1 = 0) gebildet. Die Schicht -11- dient als Zwischenschicht, um eine gute Anbindung zwischen dem Hartmetallkörper -10- und der nachfolgenden Schicht zu gewährleisten.

Unmittelbar auf der Oberfläche der Schicht -11- ist eine Schicht -12- $TiC_{x2}N_{y2}O_{z2}$ mit x2 + y2 + z2 = 1, 0,01 $\leq$ z2 $\leq$ 0,02 und 0,5 $\leq$ x2 $\leq$ 0,85 abgeschieden, die eine Dicke zwischen 5 $\mu$m und 15 $\mu$m aufweist. Bei dem in den Fig. 1 bis 3 dargestellten Beispiel weist die Schicht -12- eine Dicke von ca. 10 $\mu$m auf. Bei dem in den Fig. 1 bis 3 dargestellten Beispiel weist die Schicht -12- beispielsweise eine Zusammensetzung von etwa $TiC_{0,59}N_{0,41}$ mit Spuren O auf, mit 0,01 $\leq$ z2 $\leq$ 0,02. Die Schicht -12- ist durch einen Mitteltemperaturprozess aus $TiCl_4$ und $CH_3CN$ als Precursoren mit einer graduellen Dotierung mittels CO hergestellt. Die Schicht -12- weist plattenartige, stängelige Kristalle auf, wie in Fig. 3 zu sehen ist. Es wurde festgestellt, dass eine Flussrate CO bei dem Mitteltemperaturprozess von zwischen ca. 0,21/min und ca. 11/min sich besonders vorteilhaft auf die Bildung der gewünschten Schicht -12- auswirkt. Die Schicht -12- ist derart ausgebildet, dass sie eine Vorzugs-Texturierung in der (31 1)-Richtung mit einem Texturkoeffizienten $TC_{311} \geq$ 1,3 aufweist. Dabei bestimmt sich $TC_{311}$ über die Formel:

$$TC_{(hkl)} = \frac{I_{(hkl)} / I_{0,(hkl)}}{1/n \sum I_{(hkl)} / I_{0,(hkl)}}$$

wobei $I_{(hkl)}$, die Intensität bezeichnet, die bezüglich dem jeweiligen (hkl)-Wert gemessen wurde (aus zumindest einem entsprechenden Peak), $I_{0,(hkl)}$ die entsprechende normierte Intensität gemäß der JCPDS- (bzw. JCPDF-) Datenbank bezeichnet und n als Index über alle bezüglich der jeweiligen Zusammensetzung erwarteten Intensitäten zu (hkl)-Werten verläuft. Es hat sich herausgestellt, dass insbesondere die gezielte Beimischung von CO in dem Prozessgas, die eine graduelle Dotierung der Schicht -12- mit O bewirkt, in Kombination mit der Vorzugs-Texturierung in der (311)-Richtung dazu führt, dass sich die Spannungsverhältnisse in der gesamten mehrlagigen Beschichtung besonders gut einstellen lassen und dass die einzelnen Schichten einen besonders stabilen Verbund ergeben. Dabei hat sich ein Bereich 0,01$\leq$z2$\leq$ 0,02 als wesentlich herausgestellt. Es kann die Spannung in der Schicht -12- in dieser Weise auf einem relativ niedrigen Zugspannungsniveau gehalten werden. Die resultierende Schichtspannung in der derart ausgebildeten Schicht (als Einzelschicht) wurde nach der $\sin^2\psi$-Methode ermittelt und beträgt ca. $200 \pm 47$ MPa. Die Eindringhärte $H_{IT}$ 0,003/30/1/30 der Einzelschicht wurde gemäß EN ISO 14577-1 ermittelt und beträgt ca. $29,1 \pm 1,3$ GPa.

Unmittelbar auf der Schicht -12- ist zumindest eine Schicht -13- ausgebildet, die aus TiN oder $TiC_{x31}N_{y31}$ oder $TiN_{y32}B_{y32}$ gebildet ist. Dabei gilt $0,2 \leq x31 \leq 0,8$ und $x31 + y31 = 1$ bzw. $0,0001 \leq v32 \leq 0,05$ und $y32 + v32 = 1$. Die Schicht -13- weist dabei eine Schichtdicke zwischen 0,1 $\mu$m und 3 $\mu$m auf. Bei dem in Fig. 1 und 2 dargestellten Beispiel weist die Schicht eine mittlere Schichtdicke von ca. 0,5 $\mu$m auf. Unmittelbar auf der Schicht -13- ist zumindest eine Schicht -14- ausgebildet, die aus $TiN_{y41}B_{v41}O_{z41}$ oder $TiC_{x42}N_{y42}O_{z42}$ gebildet ist. Dabei gilt $y41 + v41 + z41 = 1$ und $0,0001 \leq v41 \leq 0,05$ und $0,01 \leq z41 \leq 0,3$ bzw. $x42 + y42 + z42 = 1$ und $0 \leq y42 \leq 0,5$ und $0,01 \leq z42 \leq 0,3$. Die Schicht -14- weist dabei eine Schichtdicke zwischen 0,01 $\mu$m und 0,5 $\mu$m auf. Die Schichten -13- und -14- dienen u.a. dazu, eine besonders gute Anbindung an die darauf folgende Außenschicht -15- aus $\kappa$-$Al_2O_3$ bereitzustellen. Diese Anbindung wird insbesondere durch die angegebene Schichtfolge besonders vorteilhaft erzielt. Die Schichten -13- und -14- sind aus den Precursoren $TiCl_4$, $N_2$, $CH_4$, $H_2$, $BCl_3$ und CO sowie über verschiedene Ätz- und Spülschritte hergestellt. Es hat sich als besonders vorteilhaft herausgestellt, wenn bei der Erzeugung der Schicht -14- außer über CO kein weiterer Kohlenstoff im Prozessgas enthalten ist. Die Schichten -13- und -14- weisen jeweils feinkörnige bis lamellar verästelte Kristalle auf. Insbesondere die Schicht -14- hat großen Einfluss auf die im Folgenden beschriebene Außenschicht -15- aus $\kappa$-$Al_2O_3$, insbesondere auf deren Korngrößenverteilung und auf die Orientierung der Kristallite bzw. die Textur.

Unmittelbar auf der Schicht -14- ist die Außenschicht -15- aus $\kappa$-$Al_2O_3$ ausgebildet. Die Außenschicht -15- aus $\kappa$-$Al_2O_3$ weist eine Schichtdicke zwischen 2 $\mu$m und 10 $\mu$m auf, bevorzugt zwischen 3,5 $\mu$m und 6,5 $\mu$m. Bei dem in den Fig. 1 und 2 dargestellten Beispiel weist die Außenschicht -15- eine Schichtdicke von ca. 5 $\mu$m auf. Die Außenschicht -15- aus $\kappa$-$Al_2O_3$ weist in einer Ebene parallel zu der Schichtoberfläche eine mittlere Korngröße kleiner als 3 $\mu$m auf, bevorzugt zwischen 1,3 $\mu$m und 1,8 $\mu$m. Die mittlere Korngröße wurde dabei über die gemittelte quadratische Seitenlänge aus der Anzahl der Individuen (Kristallite auf der Oberfläche) pro Fläche bestimmt, wobei als Basis eine rasterelektronenmikroskopische Aufnahme der Oberfläche der Außenschicht -15- diente. D.h. es wurde die Anzahl der Kristallite pro Fläche ermittelt und angenommen, dass diese jeweils quadratische Grundflächen aufweisen. Daraus wurde dann die mittlere Korngröße bestimmt. Die Außenschicht -15- aus $\kappa$-$Al_2O_3$ ist durch eine einlagige Schicht gebildet. Eine gesicherte Abscheidung der $\kappa$-$Al_2O_3$-Schicht -15- kann über eine gezielte Chlorierung und exakte Einstellung des Sauerstoffpartialdrucks aus den Precursoren HCl, $AlCl_3$, $CO_2$, $H_2S$ und $H_2$ erfolgen. Die Außenschicht -15- aus $\kappa$-$Al_2O_3$ weist Vorzugstexturierungen in der (110)-Richtung, in der (004)-Richtung und in der (015)-Richtung auf. Für den Texturkoeffizienten für die (110)-Richtung gilt $TC_{(110)} \geq 1,3$. Für den Texturkoeffizienten für die (004)-Richtung gilt $TC_{(004)} \geq 1,3$ und für den Texturkoeffizienten für die (015)-Richtung gilt $TC_{(015)} \geq 1,3$. Insbesondere ist der Texturkoeffizient für die (11 0)-Richtung jeweils größer als die Texturkoeffizienten für die (004)-Richtung und die (015)-Richtung, d.h. $TC_{(110)} > TC_{(004)}$ und $TC_{(110)} > TC_{(015)}$. Bei der in Fig. 1 und 2 dargestellten beispielhaften Außenschicht -15-wurden z.B. gemessen: $TC_{(110)}$ = 2,7; $TC_{(004)}$ = 1,85 und $TC_{(015)}$ = 1,73. Für die Bestimmung der jeweiligen Texturkoeffizienten für die Außenschicht -15- und die Schicht -12- wurden dabei jeweils GA-XRD-Messungen (x-ray diffraction, Röntgenbeugung) mit Cu $K_\alpha$-Strahlung durchgeführt und die Texturkoeffizienten unter Bezug auf die JCPDS-Datenbank (bzw. JCPDF-Datenbank) mit der zuvor bereits angegebenen Formel berechnet. Die derart abgeschiedene Außenschicht -15- aus $\kappa$-$Al_2O_3$ weist bei dem dargestellten Beispiel eine gemäß EN ISO 14577-1 ermittelte Eindringhärte HIT 0,003/30/1/30 von $22,5 \pm 0,5$ GPa auf.

Die Oberfläche der Außenschicht -15- aus $\kappa$-$Al_2O_3$ wurde in einem Nassdruckstrahlverfahren nachbehandelt. Diese Nachbehandlung bewirkt eine signifikante Modifizierung der Oberfläche in Bezug auf Rauheit und Spannungen in den oberen Schichten der mehrlagigen Beschichtung. In dem Nassdruckstrahlverfahren wurde $Al_2O_3$-Pulver in wässriger Lösung verwendet, wobei Versuche mit Größenverteilungen mit Mesh-Werten 500, 280/320 und 180/220 durchgeführt wurden. Die besten Ergebnisse wurden mit dem Mesh-Wert 280/300 und Strahldrücken zwischen ca. 3 bar und 4 bar bei einem Einstrahlwinkel auf die Oberfläche zwischen 35° und 45° erzielt. In dem funktionalen Oberflächenbereich wurden dabei Oberflächenrauheiten mit Werten Ra < 0,25 $\mu$m erzielt, wobei diese Werte mittels Lichtinterferenzverfahren bestimmt wurden.

Mit der beschriebenen Oberflächenbehandlung wurde dabei erreicht, dass sich in der Außenschicht -15- $\kappa$-$Al_2O_3$ insgesamt eine mittlere Spannung zwischen -100 MPa (Druckspannung) und 700 MPa (Zugspannung) ausbildet und dabei ein äußerster Randbereich der Außenschicht -15- $\kappa$-$Al_2O_3$, der an der Oberfläche befindet, eine mittlere Druckspannung aufweist. In dieser Weise wurden somit in dem äußersten Randbereich der Außenschicht -15-vorteilhaft Druckspannungen erzielt, die eine gute Beständigkeit der Oberfläche bewirken. Gleichzeitig wurde in der Außenschicht -15- ein Spannungsgradient in der Richtung zu den darunterliegenden Schichten erreicht, der zu einer besonderen Stabilität und Beständigkeit der mehrlagigen Beschichtung (-11-, -12-, -13-, -14-, -15-) führt. Diese vorteilhaften Spannungsverhältnisse können insbesondere auf die relativ hohe plastische Verformbarkeit der Außenschicht -15- $\kappa$-$Al_2O_3$ in Verbindung mit der Dotierung der Schicht -12- mit Sauerstoff in Kombination mit der Oberflächenbehandlung durch das Druckstrahlverfahren zurückgeführt werden.

Die Bestimmung der Dicken der einzelnen beschriebenen Schichten erfolgte über ein geätztes lichtmikroskopisches Schliffbild des Schneideinsatzes sowie über ein Kalottenschliffverfahren. Bei dem in den Fig. 1 und 2 gezeigten Beispiel weist die mehrlagige Beschichtung (-11-, -12-, -13-, -14-, -15-) eine mittlere Gesamtdicke von ca. 15 $\mu$m auf.

Im Folgenden werden Versuchsbeispiele beschrieben, aus denen sich ergibt, dass mit dem beschriebenen Schneidwerkzeug im Vergleich zu bekannten Schneidwerkzeugen verbesserte Eigenschaften erzielt werden. In der folgenden Tabelle sind insgesamt zehn Beispiele angegeben, die im Weiteren beschrieben werden.

| Beispiel Nr. | Einsatz-Typ | Vergleichs-Schneidwerkzeug | bearbeitetes Material | Vorschub pro Umdrehung [mm] | Schnitttiefe [mm] | Schnittgeschwindigkeit [m/min] | erzielte Verbesserung [%] |
|---|---|---|---|---|---|---|---|
| 1 | I | A | 1.7220 | 0,2 | 5 | var. | 23 |
| 2 | II | B | 1.7131 | 0,3 | 2 | 220 | 60 |
| 3 | III | C | 1.4923 | 1,25 | 2-10 | 43 | 16-33 |
| 4 | I | D | 1.6562 | 0,2 | 5 | var. | 11 |
| 5 | IV | E | 1.3505 | 0,4 | var. | 220 | 19 |
| 6 | V | F | 1.7225 | 0,4 | var. | 220 | 16 |
| 7 | VI | G | 0.6025 | 0,3 | 2 | 350 | 18 |
| 8 | VI | G | 0.6025 | 0,25 | 2 | 500 | 10 |
| 9 | VI | G | 0.7060 | 0,25 | 2 | 250 | 15 |
| 10 | VII | H | 1.7225 | 0,25 | 2,5 | 220 | 29 |

Bezüglich den Einsatztypen (Spalte 2) wird im Folgenden auf die ISO-Norm 1832 Bezug genommen, in der die verschiedenen Arten der Einsätze definiert sind. Bezüglich der verschiedenen bearbeiteten Materialien (Spalte 4) wird jeweils auf die Werkstoffnummern Bezug genommen. In der Spalte "erzielte Verbesserung [%]" ist jeweils die erzielte Verbesserung der Lebensdauer (bzw. Standzeit) des erfindungsgemäßen Schneidwerkzeugs verglichen mit dem Vergleichs-Schneidwerkzeug angegeben.

Beispiel 1

In Beispiel 1 erfolgte jeweils dieselbe Materialbearbeitung mit dem zuvor beschriebenen erfindungsgemäßen Schneidwerkzeug und einem bekannten Schneidwerkzeug A. Beide Schneidwerkzeuge wiesen eine Form (I) CNMG-432 gemäß ISO 1832 auf. Das bearbeitete Material war legierter Stahl mit der Werkstoffnummer 1.7220. Es erfolgte eine Materialbearbeitung mit einem Vorschub von 0,2 mm pro Umdrehung, einer Schnitttiefe von 5 mm und mit variierender Schnittgeschwindigkeit. Es wurden mehrere Schnitte durchgeführt. Die mehrlagige Beschichtung des Schneidwerkzeugs A wies in der Richtung von einem Hartmetallkörper zu der Oberfläche die folgenden Schichten auf: eine ca. 0,3 $\mu$m dicke TiN-Schicht, eine ca. 6,3 $\mu$m dicke $TiC_xN_y$-Schicht, eine ca. 0,2 $\mu$m dicke $TiC_xN_yO_z$-Schicht, eine ca. 0,4 $\mu$m dicke $TiC_xN_y$-Schicht, eine ca. 0,6 $\mu$m dicke $TiC_xN_yO_z$-Schicht und eine ca. 5,5 $\mu$m dicke Außenschicht aus $\alpha$-$Al_2O_3$.

Mit dem erfindungsgemäßen Schneidwerkzeug wurde gegenüber dem Schneidwerkzeug A eine Verbesserung der Haltbarkeit (bzw. Standzeit) von 23% erreicht.

Beispiel 2

In Beispiel 2 erfolgte jeweils dieselbe Materialbearbeitung mit dem zuvor beschriebenen erfindungsgemäßen Schneidwerkzeug und einem bekannten Schneidwerkzeug B. Beide Schneidwerkzeuge wiesen eine Form (II) WNMG060408 gemäß ISO 1832 auf. Das bearbeitete Material war legierter Stahl mit der Werkstoffnummer 1.7131. Es erfolgte eine Materialbearbeitung mit einem Vorschub von 0,3 mm pro Umdrehung, einer Schnitttiefe von 2 mm und mit einer Schnittgeschwindigkeit von 220 m/min. Die mehrlagige Beschichtung des Schneidwerkzeugs B wies dieselbe Schichtfolge wie das in Beispiel 1 beschriebene Schneidwerkzeug A auf.

Mit dem erfindungsgemäßen Schneidwerkzeug wurde gegenüber dem Schneidwerkzeug B eine Verbesserung der Haltbarkeit (bzw. Standzeit) von 60% erreicht.

Beispiel 3

In Beispiel 3 erfolgte jeweils dieselbe Materialbearbeitung mit dem zuvor beschriebenen erfindungsgemäßen Schneidwerkzeug und einem bekannten Schneidwerkzeug C. Beide Schneidwerkzeuge wiesen eine Form (III) SNMM250732 gemäß ISO 1832 auf. Das bearbeitete Material war nichtrostender Stahl mit der Werkstoffnummer 1.4923. Es erfolgte eine Materialbearbeitung mit einem Vorschub von 1,25 mm pro Umdrehung, einer Schnitttiefen zwischen 2 mm und 10 mm und mit einer Schnittgeschwindigkeit von 43 mm/min. Die mehrlagige Beschichtung des Schneidwerkzeugs C wies in der Richtung von einem Hartmetallkörper zu der Oberfläche die folgenden Schichten auf: eine ca. 0,3 $\mu$m dicke TiN-Schicht, eine ca. 9 $\mu$m dicke $TiC_xN_y$-Schicht und eine ca. 4 $\mu$m dicke Außenschicht aus $\alpha$-$Al_2O_3$. Auf der Außenschicht war eine ca. 3 $\mu$m dicke TiN-Schicht aufgebracht.

Mit dem erfindungsgemäßen Schneidwerkzeug wurde gegenüber dem Schneidwerkzeug C eine Verbesserung der Haltbarkeit (bzw. Standzeit) zwischen 16% und 33% erreicht.

Beispiel 4

In Beispiel 1 erfolgte jeweils dieselbe Materialbearbeitung mit dem zuvor beschriebenen erfindungsgemäßen Schneidwerkzeug und einem bekannten Schneidwerkzeug D. Beide Schneidwerkzeuge wiesen die Form (I) CNMG-432 gemäß ISO 1832 auf. Das bearbeitete Material war legierter Stahl mit der Werkstoffnummer 1.6562. Es erfolgte eine Materialbearbeitung mit einem Vorschub von 0,2 mm pro Umdrehung, einer Schnitttiefe von 5 mm und mit variierender Schnittgeschwindigkeit. Es wurden mehrere Schnitte durchgeführt. Die mehrlagige Beschichtung des Schneidwerkzeugs D wies denselben Aufbau wie das zu Beispiel 3 beschriebene Schneidwerkzeug C auf.

Mit dem erfindungsgemäßen Schneidwerkzeug wurde gegenüber dem Schneidwerkzeug D eine Verbesserung der Haltbarkeit (bzw. Standzeit) von 11% erreicht.

Beispiel 5

In Beispiel 5 erfolgte jeweils dieselbe Materialbearbeitung mit dem zuvor beschriebenen erfindungsgemäßen Schneidwerkzeug, an dem die Oberflächenbehandlung durch das Druckstrahlverfahren durchgeführt wurde, und einem identisch ausgebildeten Schneidwerkzeug E, bei dem die Oberflächenbehandlung durch das Druckstrahlverfahren nicht durchgeführt wurde. Beide Schneidwerkzeuge wiesen eine Form (IV) CNMG 120412 gemäß ISO 1832 auf. Das bearbeitete Material war 100Cr6 mit der Werkstoffnummer 1.3505.

Es erfolgte eine Materialbearbeitung mit einem Vorschub von 0,4 mm pro Umdrehung, variierender Schnitttiefe und mit einer Schnittgeschwindigkeit von 220 m/min. Es wurden nass Segmente geschnitten.

Mit dem Schneidwerkzeug, an dem die Oberflächenbehandlung durch das Druckstrahlverfahren durchgeführt wurde, wurde eine Verbesserung der Haltbarkeit (bzw. Standzeit) von 19% erreicht.

Beispiel 6

In Beispiel 6 erfolgte jeweils dieselbe Materialbearbeitung mit dem zuvor beschriebenen erfindungsgemäßen Schneidwerkzeug, an dem die Oberflächenbehandlung durch das Druckstrahlverfahren durchgeführt wurde, und einem identisch ausgebildeten Schneidwerkzeug F, bei dem die Oberflächenbehandlung durch das Druckstrahlverfahren nicht durchgeführt wurde. Beide Schneidwerkzeuge wiesen eine Form (V) CNMG 120812 gemäß ISO 1832 auf. Das bearbeitete Material war 42CrMo4 mit der Werkstoffnummer 1.7225. Es erfolgte eine Materialbearbeitung mit einem Vorschub von 0,4 mm pro Umdrehung, variierender Schnitttiefe und mit einer Schnittgeschwindigkeit von 220 m/min. Es wurden nass Segmente geschnitten.

Mit dem Schneidwerkzeug, an dem die Oberflächenbehandlung durch das Druckstrahlverfahren durchgeführt wurde, wurde eine Verbesserung der Haltbarkeit (bzw. Standzeit) von 16% erreicht.

Beispiel 7

In Beispiel 7 erfolgte jeweils dieselbe Materialbearbeitung mit dem zuvor beschriebenen erfindungsgemäßen Schneidwerkzeug und einem Schneidwerkzeug G. Beide Schneidwerkzeuge wiesen eine Form (VI) CNMA 120408 gemäß ISO 1832 auf. Das bearbeitete Material war GG25 mit der Werkstoffnummer 0.6025. Es erfolgte eine Materialbearbeitung mit einem Vorschub von 0,3 mm pro Umdrehung, einer Schnitttiefe von 2 mm und mit einer Schnittgeschwindigkeit von 350 m/min. Es wurde trocken längsgedreht. Die mehrlagige Beschichtung des Schneidwerkzeugs G wies in der Richtung von einem Hartmetallkörper zu der Oberfläche die folgenden Schichten auf: eine ca. 0,3 $\mu$m dicke TiN-Schicht, eine ca. 5,5 $\mu$m dicke $TiC_xN_y$-Schicht, eine ca. 0,7 $\mu$m dicke $TiC_xN_yO_z$-Schicht und eine ca. 4,5 bis 5 $\mu$m dicke Außenschicht aus $\alpha$-$Al_2O_3$. Auf der Außenschicht war ferner eine ca. 1 $\mu$m dicke Schicht aus $TiC_xN_y$ ausgebildet.

Mit dem erfindungsgemäßen Schneidwerkzeug wurde gegenüber dem Schneidwerkzeug G eine Verbesserung der Haltbarkeit (bzw. Standzeit) von 18% erreicht.

Beispiel 8

In Beispiel 8 erfolgte jeweils dieselbe Materialbearbeitung mit dem zuvor beschriebenen erfindungsgemäßen Schneidwerkzeug und dem in Beispiel 7 beschriebenen Schneidwerkzeug G. Das bearbeitete Material entspricht Beispiel 7. Es erfolgte eine Materialbearbeitung mit einem Vorschub von 0,25 mm pro Umdrehung, einer Schnitttiefe von 2 mm und mit einer Schnittgeschwindigkeit von 500 m/min. Es wurde nass längsgedreht.

Mit dem erfindungsgemäßen Schneidwerkzeug wurde gegenüber dem Schneidwerkzeug G eine Verbesserung der Haltbarkeit (bzw. Standzeit) von 10% erreicht.

Beispiel 9

In Beispiel 9 erfolgte jeweils dieselbe Materialbearbeitung mit dem zuvor beschriebenen erfindungsgemäßen Schneidwerkzeug und dem in Beispiel 7 beschriebenen Schneidwerkzeug G. Das bearbeitete Material war GGG60 mit der Werkstoffnummer 0.7060. Es erfolgte eine Materialbearbeitung mit einem Vorschub von 0,25 mm pro Umdrehung, einer Schnitttiefe von 2 mm und mit einer Schnittgeschwindigkeit von 250 m/min. Es wurde längsgedreht.

Mit dem erfindungsgemäßen Schneidwerkzeug wurde gegenüber dem Schneidwerkzeug G eine Verbesserung der Haltbarkeit (bzw. Standzeit) von 15% erreicht.

Beispiel 10

In Beispiel 10 erfolgte jeweils dieselbe Materialbearbeitung mit dem zuvor beschriebenen erfindungsgemäßen Schneidwerkzeug und einem Schneidwerkzeug H. Beide Schneidwerkzeuge wiesen eine Form (VII) CNMG 120408 gemäß ISO 1832 auf. Das bearbeitete Material war legierter Stahl mit der Werkstoffnummer 1.7225. Es erfolgte eine Materialbearbeitung mit einem Vorschub von 0,25 mm pro Umdrehung, einer Schnitttiefe von 2,5 mm und mit einer Schnittgeschwindigkeit von 220 m/min. Es wurde längsgedreht.

Die mehrlagige Beschichtung des Schneidwerkzeugs H wies in der Richtung von einem Hartmetallkörper zu der Oberfläche die folgenden Schichten auf: eine ca. 0,3 $\mu$m dicke TiN-Schicht, eine ca. 3-4 $\mu$m dicke TiC$_x$N$_y$-Schicht, eine ca. 2,5 $\mu$m dicke TiC$_x$N$_y$-Schicht (mit anderen x- und y-Werten), eine ca. 0,4 $\mu$m dicke TiN$_y$B$_v$-Schicht und eine ca. 2 $\mu$m dicke Außenschicht aus $\kappa$-Al$_2$O$_3$. Auf der Außenschicht war ferner eine ca. 0,2-0,3 $\mu$m dicke TiN-Schicht ausgebildet.

Mit dem erfindungsgemäßen Schneidwerkzeug wurde eine Verbesserung der Haltbarkeit (bzw. Standzeit) von 29% erreicht.

## Patentansprüche

1. Schneidwerkzeug zur Bearbeitung metallischer Werkstoffe mit einem Hartmetallkörper (10) und einer in zumindest einem Oberflächenbereich auf den Hartmetallkörper (10) aufgebrachten mehrlagigen Beschichtung,

   wobei die mehrlagige Beschichtung in einer Richtung von dem Hartmetallkörper (10) zu der Oberfläche (O) des Schneidwerkzeugs in der folgenden Reihenfolge aufweist:

   zumindest eine Schicht (11) TiC$_{x1}$N$_{y1}$ mit x1 + y1 = 1, x1 $\geq$ 0, y1 > 0;
   zumindest eine Schicht (12) TiC$_{x2}$N$_{y2}$O$_{z2}$ mit x2 + y2 + z2 = 1, 0,01 $\leq$ z2 $\leq$ 0,02 und 0,5 $\leq$ x2 $\leq$ 0,85;
   zumindest eine Schicht (13): TiN, oder TiC$_{x31}$N$_{y31}$ mit 0,2 $\leq$ x31 $\leq$ 0,8 und x31 + y31 = 1, oder TiN$_{y32}$B$_{v32}$ mit 0,0001 $\leq$ v32 $\leq$ 0,05 und y32 + v32 = 1;
   zumindest eine Schicht (14): TiN$_{y41}$B$_{v41}$O$_{z41}$ mit y41 + v41 + z41 = 1 und 0,0001 $\leq$ v41 $\leq$ 0,05 und 0,01 $\leq$ z41 $\leq$ 0,6, oder TiC$_{x42}$N$_{y42}$O$_{z42}$ mit x42 + y42 + z42 = 1 und 0 $\leq$ y42 $\leq$ 0,5 und 0,01 $\leq$ z42 $\leq$ 0,6; und
   zumindest eine Außenschicht (15) $\kappa$-Al$_2$O$_3$, wobei die zumindest eine Schicht (12) TiC$_{x2}$N$_{y2}$O$_{z2}$ eine Texturierung in der (31 1)-Richtung mit einem Texturkoeffizienten TC$_{(311)}$ $\geq$ 1,3 sowie plattenartige, stängelige Kristalle aufweist.

2. Schneidwerkzeug nach Anspruch 1, **dadurch gekennzeichnet, dass** die zumindest eine Außenschicht (15) $\kappa$-Al$_2$O$_3$ eine mittlere Spannung zwischen -100 MPa (Druckspannung) und 700 MPa (Zugspannung) aufweist.

3. Schneidwerkzeug nach einem der vorhergehenden Ansprüche, **dadurch gekennzeichnet, dass**:

   die zumindest eine Schicht (11) TiC$_{x1}$N$_{y1}$ eine Schichtdicke zwischen 0,1 $\mu$m und 1 $\mu$m aufweist,
   die zumindest eine Schicht (12) TiC$_{x2}$N$_{y2}$O$_{z2}$ eine Schichtdicke zwischen 5 $\mu$m und 15 $\mu$m aufweist,
   die zumindest eine Schicht (13) TiN oder TiC$_{x31}$N$_{y31}$ oder TiN$_{y32}$B$_{32}$ eine Schichtdicke zwischen 0,1 $\mu$m und 3 $\mu$m aufweist,
   die zumindest eine Schicht (14) TiN$_{y41}$B$_{v41}$O$_{z41}$ oder TiC$_{x42}$N$_{y42}$O$_{z42}$ eine Schichtdicke zwischen 0,01 $\mu$m und 0,5 $\mu$m aufweist, und
   die zumindest eine Außenschicht (15) $\kappa$-Al$_2$O$_3$ eine Schichtdicke zwischen 2 $\mu$m und 10 $\mu$m aufweist.

4. Schneidwerkzeug nach einem der vorhergehenden Ansprüche, **dadurch gekennzeichnet, dass** die zumindest eine Außenschicht (15) $\kappa$-Al$_2$O$_3$ in einer Ebene parallel zu der Schichtoberfläche (O) eine Korngröße kleiner als 3 $\mu$m aufweist.

5. Schneidwerkzeug nach einem der vorhergehenden Ansprüche, **dadurch gekennzeichnet, dass** der Hartmetallkörper (10) aus WC mit 5,5-10 Gew.% Co und 5-9 Gew.% kubischen Karbiden zumindest eines Metalls der Gruppen IVb, Vb, VIb des Periodensystems besteht.

6. Schneidwerkzeug nach Anspruch 6, **dadurch gekennzeichnet, dass** der Hartmetallkörper (10) eine Randzone mit einer Dicke zwischen 5 $\mu$m und 30 $\mu$m aufweist, in der der Anteil an Co im Verhältnis zum Inneren des Hartmetallkörpers erhöht und der Anteil an kubischen Karbiden zumindest eines Metalls der Gruppen IVb, Vb, VIb des Periodensystems im Verhältnis zum Inneren des Hartmetallkörpers (10) verringert ist.

7. Schneidwerkzeug nach einem der vorhergehenden Ansprüche, **dadurch gekennzeichnet, dass** die zumindest eine Außenschicht (15) eine einlagige Schicht $\kappa$-Al$_2$O$_3$ ist.

8. Schneidwerkzeug nach einem der vorhergehenden Ansprüche, **dadurch gekennzeichnet, dass** die mehrlagige Beschichtung angrenzend an den Hartmetallkörper (10) zumindest eine Schicht TiN mit einer Schichtdicke bis zu 1 $\mu$m aufweist.

**9.** Schneidwerkzeug nach einem der vorhergehenden Ansprüche, **dadurch gekennzeichnet, dass** die zumindest eine Schicht (13) TiN oder $TiC_{x31}N_{y31}$ oder $TiN_{y32}B_{v32}$ feinkörnige bis lamellar verästelte Kristalle aufweist.

**10.** Schneidwerkzeug nach einem der vorhergehenden Ansprüche, **dadurch gekennzeichnet, dass** die zumindest eine Schicht (14) $TiN_{y41}B_{v41}O_{z41}$ oder $TiC_{x42}N_{y42}O_{z42}$ feinkörnige bis lamellar verästelte Kristalle aufweist.

**11.** Schneidwerkzeug nach einem der vorhergehenden Ansprüche, **dadurch gekennzeichnet, dass** die zumindest eine Außenschicht (15) $\kappa$-$Al_2O_3$ mechanisch geglättet, insbesondere durch Druckstrahlglättung gestrahlt, ist.

**Claims**

**1.** Cutting tool for machining metallic materials, comprising a hard metal body (10) and a multilayer coating applied to the hard metal body (10) in at least one surface region, wherein the multilayer coating comprises the following in the following order in a direction from the hard metal body (10) to the surface (O) of the cutting tool:

at least one layer (11) $TiC_{x1}N_{y1}$, where x1 + y1 = 1, x1 $\geq$ 0, y1 > 0;
at least one layer (12) $TiC_{x2}N_{y2}O_{z2}$, where x2 + y2 + z2 = 1, 0.01 $\leq$ z2 $\leq$ 0.02 and 0.5 $\leq$ x2 $\leq$ 0.85;
at least one layer (13): TiN, or $TiC_{x31}N_{y31}$, where 0.2 $\leq$ x31 $\leq$ 0.8 and x31 + y31 = 1, or $TiN_{y32}B_{v32}$, where 0.0001 $\leq$ v32 $\leq$ 0.05 and y32 + v32 = 1;
at least one layer (14): $TiN_{y41}B_{v41}O_{z41}$, where y41 + v41 + z41 = 1 and 0.0001 $\leq$ v41 $\leq$ 0.05 and 0.01 $\leq$ z41 $\leq$ 0.6, or $TiC_{x42}N_{y42}O_{z42}$, where x42 + y42 + z42 = 1 and 0 $\leq$ y42 $\leq$ 0.5 and 0.01 $\leq$ z42 $\leq$ 0.6; and
at least one outer layer (15) $\kappa$-$Al_2O_3$,
wherein the at least one layer (12) $TiC_{x2}N_{y2}O_{z2}$ has a texturing in the (311) direction with a texture coefficient $TC_{(311)} \geq$ 1.3 and comprises plate-like, columnar crystals.

**2.** Cutting tool according to Claim 1, **characterized in that** the at least one outer layer (15) $\kappa$-$Al_2O_3$ has a mean stress of between -100 MPa (compressive stress) and 700 MPa (tensile stress).

**3.** Cutting tool according to any one of the preceding claims, **characterized in that**:

the at least one layer (11) $TiC_{x1}N_{y1}$ has a layer thickness of between 0.1 $\mu$m and 1 $\mu$m,
the at least one layer (12) $TiC_{x2}N_{y2}O_{z2}$ has a layer thickness of between 5 $\mu$m and 15 $\mu$m,
the at least one layer (13) TiN or $TiC_{x31}N_{y31}$ or $TiN_{y32}B_{v32}$ has a layer thickness of between 0.1 $\mu$m and 3 $\mu$m,
the at least one layer (14) $TiN_{y41}B_{v41}O_{z41}$ or $TiC_{x42}N_{y42}O_{z42}$ has a layer thickness of between 0.01 $\mu$m and 0.5 $\mu$m, and
the at least one outer layer (15) $\kappa$-$Al_2O_3$ has a layer thickness of between 2 $\mu$m and 10 $\mu$m.

**4.** Cutting tool according to any one of the preceding claims, **characterized in that** the at least one outer layer (15) $\kappa$-$Al_2O_3$ has a grain size of less than 3 $\mu$m in a plane parallel to the layer surface (O).

**5.** Cutting tool according to any one of the preceding claims, **characterized in that** the hard metal body (10) consists of WC and 5.5-10% by weight Co and 5-9% by weight cubic carbides of at least one metal from groups IVb, Vb, VIb of the periodic system.

**6.** Cutting tool according to Claim 6, **characterized in that** the hard metal body (10) has a marginal zone which has a thickness of between 5 $\mu$m and 30 $\mu$m and in which the proportion of Co is increased in relation to the interior of the hard metal body and the proportion of cubic carbides of at least one metal from groups IVb, Vb, VIb of the periodic system is reduced in relation to the interior of the hard metal body (10).

**7.** Cutting tool according to any one of the preceding claims, **characterized in that** the at least one outer layer (15) is a single-layer coating $\kappa$-$Al_2O_3$.

**8.** Cutting tool according to any one of the preceding claims, **characterized in that** the multilayer coating comprises at least one layer TiN having a layer thickness of up to 1 $\mu$m adjoining the hard metal body (10).

**9.** Cutting tool according to any one of the preceding claims, **characterized in that** the at least one layer (13) TiN or $TiC_{x31}N_{y31}$ or $TiN_{y32}B_{v32}$ comprises fine-grained to lamellar dendritic crystals.

**10.** Cutting tool according to any one of the preceding claims, **characterized in that** the at least one layer (14) $TiN_{y41}B_{v41}O_{z41}$ or $TiC_{x42}N_{y42}O_{z42}$ comprises fine-grained to lamellar dendritic crystals.

**11.** Cutting tool according to any one of the preceding claims, **characterized in that** the at least one outer layer (15) $\kappa$-$Al_2O_3$ is mechanically smoothed, in particular blasted by pressurized-jet smoothing.

## Revendications

**1.** Outil de coupe pour l'usinage de matériaux métalliques, présentant un corps (10) en métal dur et un revêtement multicouche appliqué dans au moins une zone de surface sur le corps (10) de métal dur, le revêtement multicouche présentant, dans un sens allant du corps (10) en métal dur vers la surface (O) de l'outil de coupe, dans l'ordre suivant :

au moins une couche (11) de $TiC_{x1}N_{y1}$ avec x1 + y1 = 1, x1 ≥ 0, y1 > 0 ;
au moins une couche (12) de $TiC_{x2}N_{y2}O_{z2}$ avec x2 + y2 + z2 = 1, 0,01 ≤ z2 ≤ 0,02 et 0,5 ≤ x2 ≤ 0,85 ;
au moins une couche (13) de TiN ou de $TiC_{x31}N_{y31}$ avec 0,2 ≤ x31 ≤ 0,8 et x31 + y31 = 1 ou de $TiN_{y32}B_{v32}$ avec 0,0001 ≤ v32 ≤ 0,05 et y32 + v32 = 1 ;
au moins une couche (14) de $TiN_{y41}B_{v41}O_{z41}$ avec y41 + v41 + z41 = 1 et 0,0001 ≤ v41 ≤ 0,05 et 0,01 ≤ z41 ≤ 0,6 ou de $TiC_{x42}N_{y42}O_{z42}$ avec x42 + y42 + z42 = 1 et 0 ≤ y42 ≤ 0,5 et 0,01 ≤ z42 ≤ 0,6 ; et
au moins une couche externe (15) de $\kappa$-$Al_2O_3$, ladite au moins une couche (12) de $TiC_{xz}N_{y2}O_{z2}$ présentant une texturation dans la direction (311) dotée d'un coefficient de texture $TC_{(311)}$ ≥ 1,3 ainsi que des cristaux de type plaquette, en forme de tige.

**2.** Outil de coupe selon la revendication 1, **caractérisé en ce que** ladite au moins une couche externe (15) de $\kappa$-$Al_2O_3$ présente une contrainte moyenne entre -100 MPa (contrainte de compression) et 700 MPa (contrainte de traction).

**3.** Outil de coupe selon l'une quelconque des revendications précédentes, **caractérisé en ce que** :

ladite au moins une couche (11) de $TiC_{x1}N_{y1}$ présente une épaisseur de couche entre 0,1 $\mu$m et 1 $\mu$m,
ladite au moins une couche (12) de $TiC_{x2}N_{y2}O_{z2}$ présente une épaisseur de couche entre 5 $\mu$m et 15 $\mu$m,
ladite au moins une couche (13) de TiN ou de $TiC_{x31}N_{y31}$ ou de $TiN_{y32}B_{v32}$ présente une épaisseur de couche entre 0,1 $\mu$m et 3 $\mu$m,
ladite au moins une couche (14) de $TiN_{y41}B_{v41}O_{z41}$ ou de $TiC_{x42}N_{y42}O_{z42}$ présente une épaisseur de couche entre 0,01 $\mu$m et 0,5 $\mu$m et
ladite au moins une couche externe (15) de $\kappa$-$Al_2O_3$ présente une épaisseur de couche entre 2 $\mu$m et 10 $\mu$m.

**4.** Outil de coupe selon l'une quelconque des revendications précédentes, **caractérisé en ce que** ladite au moins une couche externe (15) de $\kappa$-$Al_2O_3$ présente une grosseur de grain inférieure à 3 $\mu$m dans un plan parallèle à la surface (O) de couche.

**5.** Outil de coupe selon l'une quelconque des revendications précédentes, **caractérisé en ce que** le corps (10) en métal dur est constitué par du WC présentant 5,5-10% en poids de Co et 5-9% en poids de carbures cubiques présentant au moins un métal des groupes IVb, Vb, VIb du système périodique.

**6.** Outil de coupe selon la revendication 6, **caractérisé en ce que** le corps (10) en métal dur présente une zone de bord d'une épaisseur entre 5 $\mu$m et 30 $\mu$m, dans laquelle la proportion de Co est augmentée par rapport à l'intérieur du corps en métal dur et la proportion de carbures cubiques d'au moins un métal des groupes IVb, Vb, VIb du système périodique est diminuée par rapport à l'intérieur du corps (10) en métal dur.

**7.** Outil de coupe selon l'une quelconque des revendications précédentes, **caractérisé en ce que** ladite au moins une couche externe (15) est une monocouche de K-$Al_2O_3$.

**8.** Outil de coupe selon l'une quelconque des revendications précédentes, **caractérisé en ce que** le revêtement multicouche présente, à côté du corps (10) en métal dur, au moins une couche TiN d'une épaisseur de couche allant jusqu'à 1 $\mu$m.

**9.** Outil de coupe selon l'une quelconque des revendications précédentes, **caractérisé en ce que** ladite au moins une couche (13) de TiN ou de $TiC_{x31}N_{y31}$ ou de $TiN_{y32}B_{v32}$ présente des cristaux en grains fins à lamellaires ramifiés.

**10.** Outil de coupe selon l'une quelconque des revendications précédentes, **caractérisé en ce que** ladite au moins une couche (14) de $TiN_{y41}B_{v41}O_{z41}$ ou de $TiC_{x42}N_{y42}O_{z42}$ présente des cristaux en grains fins à lamellaires ramifiés.

**11.** Outil de coupe selon l'une quelconque des revendications précédentes, **caractérisé en ce que** ladite au moins une couche externe (15) en $\kappa$-$Al_2O_3$ est lissée mécaniquement, en particulier par un lissage par jet sous pression.

**Fig. 1**

**Fig. 4**

**Fig. 2**

**Fig. 3**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1696051 A1
- EP 1473101 A
- EP 2208561 A

**In der Beschreibung aufgeführte Nicht-Patentliteratur**

- **I.C. NOYAN ; J.B. COHEN.** Residual Stress Measurement by Diffraction and Interpretation. Springer-Verlag, 1987, 117-130